(19) Europäisches Patentamt
European Patent Office
Office européen des brevets

(11) EP 3 612 012 A1

(12) EUROPEAN PATENT APPLICATION
published in accordance with Art. 153(4) EPC

(43) Date of publication:
**19.02.2020 Bulletin 2020/08**

(21) Application number: **18785050.8**

(22) Date of filing: **05.04.2018**

(51) Int Cl.:
***H05K 7/20*** (2006.01) ***C08K 3/00*** (2018.01)
***C08L 83/07*** (2006.01) ***C09K 5/14*** (2006.01)
***H01L 23/36*** (2006.01) ***H01L 23/373*** (2006.01)

(86) International application number:
**PCT/JP2018/014507**

(87) International publication number:
**WO 2018/190233 (18.10.2018 Gazette 2018/42)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(30) Priority: **12.04.2017 JP 2017078727**

(71) Applicant: **Denka Company Limited**
**Tokyo 103-8338 (JP)**

(72) Inventors:
- **IGARASHI Kazuyuki**
  **Shibukawa-city**
  **Gunma 377-8520 (JP)**
- **NARA Tomoyuki**
  **Shibukawa-city**
  **Gunma 377-8520 (JP)**

(74) Representative: **Rees, Kerry**
**WP Thompson**
**138 Fetter Lane**
**London EC4A 1BT (GB)**

# (54) HEAT-CONDUCTIVE SHEET AND METHOD FOR MANUFACTURING SAME

(57) Provided is a heat conductive resin composition capable of giving a resin molded article having high heat conductivity and high flexibility. A heat-conductive sheet comprises a plurality of cuts on one or both faces of the sheet. At least a part of a face formed by the cuts is preferably in contact with at least a part of another face. It is preferable that the cuts do not penetrate the sheet. The sheet preferably has a plurality of sections formed by the cuts in the longitudinal direction and/or the transverse direction. The sheet preferably comprises a silicone resin composition and an inorganic filler.

[Fig. 1]

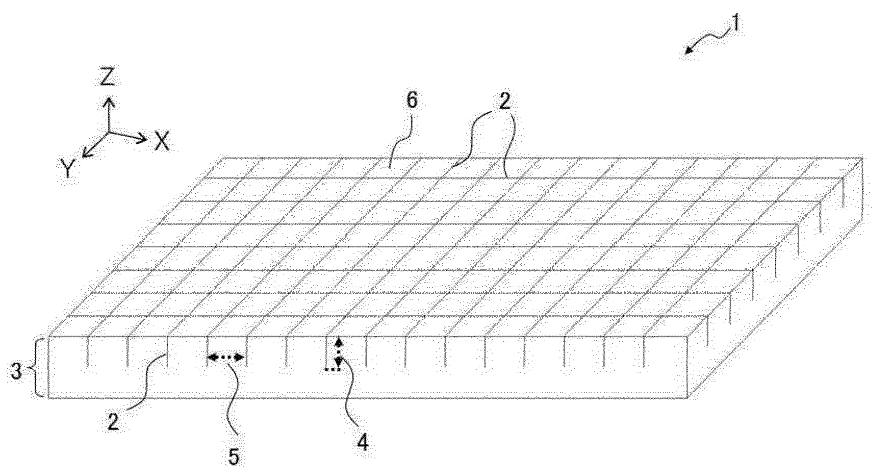




Printed by Jouve, 75001 PARIS (FR)

## Description

### Technical Field

The present invention relates to a heat-conductive sheet and a method for producing the sheet.

### Background Art

As electronic components have smaller sizes and higher output, the electronic components generate an extremely large amount of heat per unit area. Such a temperature increase may lead to a shorter lifetime, malfunctions, or failures of the electronic component. To address these problems, a metal heat sink or casing is used to cool an electronic component, and a heat-conductive material is further used for efficient heat transfer from the electronic component to a cooling unit such as a heat sink or a casing. The reason for the use of the heat-conductive material is that when an electronic component is in direct contact with a heat sink or the like, air is present microscopically on the interface therebetween to interfere with heat transfer. Hence, a heat-conductive material between the electronic component and the heat sink or the like in place of air on the interface enables efficient heat transfer.

The heat-conductive material includes a material prepared by adding a heat-conductive powder to a resin. Examples of the resin include a silicone resin, an acrylic resin, and an epoxy resin.

Examples of the heat-conductive material comprising a silicone resin include a heat-conductive sheet prepared by adding a heat-conductive filler to a silicone rubber or a silicone gel and a heat-conductive grease prepared by adding a heat-conductive filler to a silicone oil. The grease adheres to an interface more closely than the sheet, is allowed to become as thin as the largest particle size of a heat-conductive filler, and thus achieves low heat resistance. The grease, which is liquid, may cause problems of dropping or pump-out unfortunately. The sheet has excellent workability as compared with the grease and is capable of being compressed and fixed between an electronic component and a heat sink or a casing. Hence, the sheet does not cause problems of dropping or pump-out unlike the grease. However, the sheet, which is solid and is used in a compressed state, gives a large compressive stress, and use of the sheet may cause failures of an electronic component or distortion of a casing.

Patent Document 1 is intended to provide a heat-conductive silicone sheet capable of reducing the reaction force against compression while maintaining high heat dissipation property. Patent Document 1 therefore discloses a heat-conductive silicone sheet formed from a cured silicone product comprising a heat-conductive filler, and the heat-conductive silicone sheet has a plurality of holes penetrating in the thickness direction.

### Citation List

### Patent Documents

Patent Document 1: JP-A No. 2015-92534

### Summary of the Invention

### Technical Problem

The heat-conductive sheet typically includes a heat-conductive adhesive sheet and a heat-conductive non-adhesive sheet. The heat-conductive adhesive sheet is fixed to a heat-generating member or a heat-dissipating member by application of an adhesive or by the adhesiveness of the adhesive sheet itself. The heat-conductive non-adhesive sheet is failed to be fixed to a member due to the non-adhesiveness of the non-adhesive sheet and thus is interposed and fixed between a heat-generating member and a heat-dissipating member under a load with a clipping force or the like. Examples of the heat-generating member include a heat generating electronic component and a circuit board with a heat generating electronic component. The heat-dissipating member may be any member that reduces the temperature of a heat-generating member, such as a cooler.

Specifically, when a high heat-conductive sheet having excellent heat dissipation property is intended to be produced, conventionally, the sheet has a lower flexibility. When the sheet is fixed to the substrate of an electronic component, a large stress may be applied to the substrate, and the substrate may warp. The warpage of the substrate may release an element on the substrate or may apply an excess force to a heat-generating element.

When the content of an inorganic filler is reduced in order to increase the flexibility of a high heat-conductive sheet, the high heat-conductive sheet may accordingly have a higher resistance to achieve insufficient heat dissipation property.

A sheet containing an inorganic filler and a silicone resin composition is solid, and thus the sheet has excellent

heat dissipation property but has relatively poor flexibility. Hence, it is difficult to use the sheet at such a high compressibility that the sheet is interposed between a heat-generating member and a heat-dissipating member under a high load. The sheet is interposed between a heat-generating member and a heat-dissipating member under a load. Such a member has concave portions and convex portions, and thus the face of the sheet may not correspond to the concave portions and the convex portions and fail to be in close contact with the member. When such a heat-conductive sheet having poor following property to insufficient contact with a member is used, the member is damaged or the heat dissipation efficiency deteriorates in many cases. In addition, no contact with a member may reduce the heat dissipation property of the sheet.

In such circumstances, the present invention is mainly intended to provide a heat-conductive sheet having high flexibility and high heat conductivity and further having high following property.

In order to improve the following property to a contact member in an electronic device, the inventors of the present invention prepared a heat-conductive heat-dissipating spacer having a large number of grooves by carving a heat-conductive sheet prepared from a composition comprising a silicone resin composition and an inorganic filler, in the longitudinal direction to form the grooves each having a U-shaped vertical cross-section with a width of 1.5 mm. In addition, grooves with a width of 1.5 mm were formed also in the transverse direction by carving to prepare a heat-conductive heat-dissipating spacer having a large number of grooves. The prepared heat-dissipating spacer had grooves in the longitudinal and transverse directions and had a grid pattern on the face to be in contact with a member (see Table 5 in Example described later).

When such a heat-conductive heat-dissipating spacer having a large number of grooves is interposed and fixed between a heat-generating member and a heat-dissipating member, heat is accumulated and is insufficiently dissipated in response to temperature increases of convex portions and concave portions of the heat-generating member. In addition, the temperature difference between the convex portions and the concave portions is large, and the convex portions and the concave portions have large heat resistances.

The inventors of the present invention have studied a heat-conductive sheet prepared from a composition comprising a silicone resin composition and an inorganic filler and having a plurality of through-holes (circular shape) but have thought that the sheet was difficult to achieve satisfactory heat dissipation property in consideration of various experimental results of the above heat-conductive heat-dissipating spacer having grooves in the longitudinal and transverse directions and having a grid pattern on a face to be in contact with a member.

On this account, the inventors of the present invention thought at this stage that even when a grid pattern of grooves or through-holes were formed on a sheet face, a heat-conductive sheet having high flexibility and high heat conductivity and further having high following property could not be produced.

The inventors of the present invention have further carried out intensive studies and have successfully found that by forming, on a face of a heat-conductive sheet to be in contact with a member, a plurality of cuts in place of grooves having a width such as a U-shape, a sheet even containing an inorganic filler at a high content has high flexibility and high following property to a member and accordingly has a low heat resistance and satisfactory heat dissipation property. As described above, the inventors of the present invention unexpectedly have produced a high heat-conductive sheet having high flexibility and high heat conductivity and also having high following property and have completed the present invention.

The present invention provides a heat-conductive sheet having a plurality of cuts on one or both faces of the sheet.

The present invention also provides a method for producing the heat-conductive sheet.

At least a part of a face formed by the cuts may be in contact with at least a part of another face formed by the cuts.

The cuts may not penetrate the sheet.

A depth ratio of the cuts may be 2% to 90% of the thickness of the sheet. The sheet may have a plurality of sections formed by the cuts. The sections may be formed by cuts in the longitudinal direction and/or the transverse direction.

The sheet may have a compressive stress (at a compressibility of 20%) that is at least 5% smaller than that before cutting.

The sheet may have an Asker C hardness of less than 40.

The partitioned area ratio of the sections (the area of a section /the area of the sheet) may be 25% or less. The heat-conductive sheet may have a thickness of 0.3 to 10 mm.

The sheet may comprise a silicone resin composition and an inorganic filler.

The inorganic filler may be contained at 40 to 85% by volume.

The silicone resin composition may be a two-component addition reaction type liquid silicone comprising an organopolysiloxane having a vinyl group at least at an end or on a side chain and an organopolysiloxane having two or more H-Si groups at least at an end or on a side chain.

In the silicone resin composition, the organopolysiloxane having a vinyl group at least at an end or on a side chain may have a weight average molecular weight of 10,000 to 400,000, and the organopolysiloxane having two or

more H-Si groups at least at an end or on a side chain may have a weight average molecular weight of 10,000 to 400,000.

The inorganic filler may be at least one filler selected from aluminum oxide, aluminum nitride, and zinc oxide. The sheet may have a heat conductivity of 0.5 W/mK or more.

## Advantageous Effects of Invention

The present invention enables the production of a heat-conductive sheet having high flexibility and high heat conductivity and also having high following property.

## Brief Description of Drawings

Fig. 1 is a schematic view of a heat-conductive sheet as an example embodiment.

Fig. 2 is a schematic view of an example use of the heat-conductive sheet of the present invention, and the heat-conductive sheet of the present invention is interposed between a heat-generating member and a heat-dissipating member under a load.

Fig. 3 is a schematic view of an example use of the heat-conductive sheet of the present invention, and the heat-conductive sheet of the present invention is interposed between a heat-generating member and a heat-dissipating member under a load.

## Description of Embodiments

Preferred embodiments for carrying out the present invention will now be described with reference to Fig. 1 and Fig. 2 appropriately. The present invention is not intended to be limited to the following embodiments and may be freely modified within the scope of the invention. Embodiments are not intended to limit the scope of the invention.

The signs in Fig. 1 are as follows: 1, heat-conductive sheet; 2,cut; 3, thickness ; 4, cut depth; 5, cut interval; 10, electronic member; 11, heat-generating member; and 12, cooling member. X-direction is also called transverse direction, Y-direction is also called longitudinal direction, and Z-direction is also called vertical direction.

### <Heat-conductive sheet of present invention>

A heat-conductive sheet of the present invention (hereinafter also called "sheet of the present invention") has a plurality of cuts on one or both faces of the sheet. The sheet of the present invention is preferably a sheet comprising a silicone resin composition and an inorganic filler and having a plurality of cuts.

The sheet of the present invention has high heat conductivity, high flexibility, and high following property.

When a conventional heat-conductive sheet having grooves is interposed between members, air may not escape from dead spots of the grooves on the close contact face, and the heat resistance may increase.

In contrast, when the sheet of the present invention is interposed between and in close contact with a heat-generating member and a cooling member, the sheet of the present invention has an effect of laterally releasing the repulsive force vertically generated (the force in the compression direction), due to the cuts formed by a slitting process, and has a structure in which air is unlikely to enter. In addition, the sheet of the present invention has high following property to a member, thus is unlikely to apply an excess load to a member, and is capable of suppressing damages to the member. The sheet follows even a member having concave portions and convex portions to exhibit high adhesiveness. The sheet of the present invention has high adhesiveness and thus exhibits satisfactory heat dissipation property. The heat-conductive sheet of the present invention is therefore preferably used as a non-adhesive sheet that is interposed between a heat-generating member and a cooling member under a load.

### <Cuts of sheet of present invention>

The heat-conductive sheet of the present invention has a plurality of cuts on one or both faces of the sheet.

The face with the cuts may be at least one of the sheet faces (hereinafter also called sheet surfaces) to be in contact with a member. The cuts form faces in cut portions, and at least a part of a face formed by the cuts is preferably in contact with at least a part of another face.

The cut is not specifically limited and may be any of a linear cut, a perforation line cut, a polygonal cut, an elliptical cut, a circular cut, and the like.

The linear cut is not specifically limited, and examples include a linear cut, a zigzag cut, and a wavy cut. The wavy cut has a wavelike shape, and examples include of a sine wave shape, a saw-like shape, a rectangular wave

shape, a trapezoidal wave shape, and a triangular wave shape. The perforation line shape means a shape in which cut and uncut portions are repeated, including a broken line.

The polygonal cut is not specifically limited, and examples of the shape include a triangular shape, a quadrangular shape, a pentagonal shape, a hexagonal shape, and a star shape. Examples of the quadrangular shape include a trapezoidal shape, a square shape (such as a rectangular shape and a regular square shape), a diamond shape, and a parallelogram shape.

Of the above cuts, a linear cut, a wavy cut, a diamond shaped cut, a circular cut, a star shaped cut, and a square cut are preferred, a linear cut, a diamond shaped cut, and a square cut are more preferred, and a square cut (specifically a regular square cut) is particularly preferred from the viewpoint of workability in a cutting process and high following property.

For the cuts in the longitudinal direction and/or the transverse direction, one or two or more shapes are selected from the linear shape, the zigzag shape, the wavy shape, and the perforation line shape, and the cuts with such a shape are preferably formed on a sheet face. For example, when linear cutting is preformed multiple times in the longitudinal direction and the transverse direction, a section formed on a sheet face by the cutting is allowed to have a quadrangular shape (suitably a square shape). For example, linear cutting may be followed by perforation line cutting.

The length of one side of a polygonal shape is not limited to particular values, and is preferably 0.7 to 5 mm, more preferably 0.7 to 2.5 mm, and even more preferably 1.0 to 2.0 mm, for a sheet having a side length of 15 mm. For a circular cut, the "length of one side of a polygonal shape" may be the "diameter", and for an elliptical cut, the "length of one side of a polygonal shape" may be the "(major axis length + minor axis length)/2".

For the cuts of the present invention, by moving a cutting means in any of the vertical direction (Z-direction), the longitudinal direction (Y-direction), and the transverse direction (X-direction) or an appropriate combination thereof, a plurality of cuts may be formed on a sheet face to be in contact with a member. The cutting means may be used to form cuts in any direction including an "oblique direction" and a "wavy direction".

The cutting means enables processing of cuts that are not practically grooves, and the cutting process forms slits, which appear just as traces of cuts. The slit (such a linear trace that a cut face is observable (the clearance of the cut portion)) preferably has a width of 300 μm or less, and the width is preferably not less than 2 μm and less than 300 μm, more preferably 100 μm or less, even more preferably 50 μm or less, and still more preferably 2 to 50 μm. When the cut portion has a smaller clearance, air is unlikely to enter the sheet face, and such a sheet may have a low heat resistance and easily obtains flexibility and following property. Hence, such a condition has advantages.

The cutting means may be any means that enables the achievement of the above clearance conditions of the cut portions, and examples include a cutting blade, a laser irradiation unit, and an irradiation unit capable of applying water jet (water cutter). Of them, a cutting blade, which easily forms narrower slits and facilitates processing, is preferred.

As a more specific example, a cutting blade may be pushed in the upward direction and/or the downward direction to form a cut, or a cutting blade may be moved in the longitudinal direction and/or the transverse direction to form a cut. When a polygonal shape, a circular shape, a star shape, or another shape is formed in an uncut manner, a cutting die corresponding to an intended shape may be used and the cutting die may be pushed in the upward direction and/or the downward direction to form a cut. For laser cutting or water jet cutting, an irradiation unit may be moved in the longitudinal direction and/or the transverse direction to form a cut.

The cut of the present invention may have any vertical cross-sectional shape, and examples of the shape include a V-shape, a Y-shape, an I-shape, and an italic I-shape with any angle. The I-shape is represented by sign 2 for the cuts in the heat-conductive sheet 1 in Fig. 2, and the italic I-shape with any angle is represented by sign 2b for the cuts in the heat-conductive sheet 1b in Fig. 3. Of them, the I-shape (for example, see sign 2 in Fig. 1) is preferred because slits having contact faces in the vertical direction are easily formed.

The cuts preferably do not penetrate the sheet.

The length of the nonpenetration portion (the length of the uncut portion after cutting in the vertical direction) (mm) is preferably 0.1 to 6.0 mm, more preferably 0.15 to 5.0 mm, even more preferably 0.2 to 4.0 mm, and still more preferably 0.25 to 3.0 mm.

The depth ratio of the cut of the present invention is preferably 2 to 90% of the sheet thickness, more preferably 30 to 80%, and even more preferably 40 to 70%.

A sheet having cuts with a depth ratio of 2 to 90% is likely to have high flexibility and high following property and to have lower heat resistance and thus has advantages.

For a sheet having cuts on both faces, the depth ratio of the cuts is sum of the depth ratio of a cut on one side and the depth ratio of a cut on the other side.

The depth ratio of a cut may be calculated in accordance with cut rate = "cut depth from a sheet face in the vertical direction (mm)/sheet thickness (mm)" × 100.

The thickness of the sheet is not limited to particular values and is preferably 0.3 to 10 mm, more preferably 0.5 to 5.0 mm, and even more preferably 1.0 to 4.0 mm. When the sheet has a thickness of 1.0 to 4.0 mm, the following property is easily improved by a cutting process, and such a condition has advantages in terms of high heat conductivity

and high flexibility.

The sheet face to be in contact with a member preferably has a plurality of sections formed by cuts. More preferably, the sections are a plurality of sections formed by cuts in the longitudinal direction and/or the transverse direction. When having a plurality of sections, the sheet easily obtains higher adhesiveness to a member and high following property, and thus such a condition has advantages.

The section may have any shape. Examples include the above described shapes such as a polygonal shape, a circular shape, and an elliptical shape. Specifically, a square shape and a triangular shape are preferred, and a square shape (more suitably a regular square shape) is more preferred.

The number of the sections (hereinafter "the number of sections" is also called "the number of partitions") is not limited to particular numbers. At least 4 or more sections, preferably 9 or more sections, more preferably 36 or more sections, and particularly preferably 49 or more sections are provided.

As for the lower limit of the number of the sections, more suitably in a sheet area of 15 $mm^2$, preferably 36 or more sections (/15 $mm^2$), more preferably 49 or more sections (/15 $mm^2$), and even more preferably 64 or more sections (/15 $mm^2$) are provided.

The upper limit of the number of the sections is not limited to particular numbers, and more suitably in a sheet area of 15 $mm^2$, preferably 2,000 or less sections (/15 $mm^2$), more preferably 1,500 or less sections (/15 $mm^2$), even more preferably 1,000 or less sections (/15 $mm^2$), and still more preferably 500 or less sections (/15 $mm^2$) are provided.

More suitably, the number of the sections is preferably 49 (/15 $mm^2$) to 500 (/15 $mm^2$) and more preferably 64 (/15 $mm^2$) to 400 (/15 $mm^2$).

The partitioned area ratio of the sections (the area of a section/the area of the sheet) is preferably 25% or less, more preferably 15% or less, even more preferably 5% or less, and still more preferably 3% or less. The partitioned area ratio is preferably 0.1% or more.

When having a smaller partitioned area ratio of the sections, the sheet has higher adhesiveness to a member and is likely to achieve high following property. In addition, the heat resistance is reduced to achieve high heat conductivity, and such a condition has advantages.

The partitioned area ratio of the sections (the area of a section/the area of the sheet) may be calculated in accordance with "the area of a section ($mm^2$)/the whole area of a heat-conductive sheet to be in contact with a member ($mm^2$)" $\times$ 100.

The sheet preferably has an Asker C hardness (without cuts) of less than 40, more preferably 35 or less, and even more preferably 30 or less. The lower limit of the Asker C hardness is preferably 5 or more from the viewpoint of easier handling properties when the sheet is handled.

The sheet preferably has an Asker C hardness (with cuts) of 35 or less and more preferably 30 or less. The lower limit of the Asker C hardness is preferably 5 or more from the viewpoint of easier handling properties when the sheet is handled.

Cutting is suitably so performed that the difference in Asker C hardness of the sheet before and after the cutting is preferably 2 or more and more preferably 5 or more. When the difference in Asker C hardness before and after the cutting is 2 or more, and an improvement effect of flexibility is exerted, the resulting sheet obtains higher following property.

The "difference in Asker C hardness before and after cutting" may be calculated in accordance with "(Asker C hardness of a sheet with cuts - Asker C hardness of a sheet without cuts)".

The sheet of the present invention has a compressive stress (N) at a compressibility of 20% (also called "compressive stress (at a compressibility of 20%)") that is preferably 5% or more smaller, more preferably 10% or more smaller, and even more preferably 15% or more smaller than the compressive stress (N) at a compressibility of 20% before cutting. The compressive stress is preferably reduced by a cutting process.

A larger reduction rate in the compressive stress (at a compressibility of 20%) of the sheet by a slitting process in the present invention advantageously suppresses a sudden increase of the compressive stress at the initial stage before the sheet reaches the peak load in compression. The upper limit of the reduction rate is considered to be 90% or less, and the slitting process may be performed to give a reduction rate of 60% or less, 50% or less, 40% or less, 30% or less, or the like.

The sheet of the present invention has a compressive stress (N) at a compressibility of 50% (also called "compressive stress (at a compressibility of 50%)") that is preferably 5% or more smaller, more preferably 10% or more smaller, and even more preferably 15% or more smaller than the compressive stress (N) at a compressibility of 50% before cutting. The compressive stress is preferably reduced by a cutting process.

A larger reduction rate of the compressive stress (at a compressibility of 50%) of the sheet by a slitting process in the present invention advantageously suppresses an increase of the compressive stress at the later stage before the sheet reaches the peak load in compression. The upper limit of the reduction rate is considered to be 90% or less, and the slitting process may be performed to give a reduction rate of 60% or less, 50% or less, 40% or less, 30% or less, or the like.

Each of the reduction rate (at a compressibility of 20%) in the compressive stress and the reduction rate (at a

compressibility of 50%) in the compressive stress of the sheet of the present invention is preferably set at 5% or more.

The "reduction rate in the compressive stress" may be calculated in accordance with "(compressive stress without cuts - compressive stress with cuts)/(compressive stress without cuts)" × 100.

The contact area ($mm^2$) of the sheet of the present invention at a compressibility of 5% is preferably 130 $mm^2$ or more, more preferably 200 $mm^2$ or more, and more preferably 220 $mm^2$ or more in a sheet area of 225 $mm^2$ from the viewpoint of high flexibility and high following property.

<Heat-conductive composition used for sheet of present invention>

A heat-conductive composition used for the heat-conductive sheet of the present invention (hereinafter also called "heat-conductive composition") is not specifically limited.

For the sheet of the present invention, a heat-conductive composition comprising a resin composition and an inorganic filler is preferably used. For the sheet of the present invention, a heat-conductive composition comprising component (A), a silicone resin composition, and component (B), an inorganic filler, is preferably used. Use of the silicone resin composition enables the production of a heat-conductive sheet having high flexibility and high heat conductivity.

The silicone resin composition as the component (A) used in the present invention is not specifically limited. Examples of the reaction type thereof include curing reactions by peroxide crosslinking, condensation crosslinking, addition crosslinking, ultraviolet crosslinking, and other crosslinking, and the curing reaction by addition crosslinking is specifically preferred.

The silicone resin composition as the component (A) preferably comprises an addition reaction type silicone resin and more preferably comprises a one-component reaction type-silicone resin composition or a two-component addition reaction type-silicone resin composition.

The silicone resin composition as the component (A) preferably comprises a two-component addition reaction type liquid silicone containing component (a1), an organopolysiloxane having a vinyl group at least at an end or on a side chain, and component (a2), an organopolysiloxane having two or more H-Si groups at least at an end or on a side chain.

The inorganic filler as the component (B) is preferably contained at 40 to 85% by volume.

The sheet of the present invention preferably has a heat conductivity of 0.5 W/mK or more.

In the silicone resin composition as the component (A), the component (a1) and the component (a2) in the component (A) and the component (B) are reacted and cured to form a silicone rubber. Use of the components (A) and (B) enables the production of a resin molded article (for example, a sheet) having high flexibility even when the heat-conductive composition comprises the inorganic filler at a high content of 40 to 85% by volume. The inorganic filler is capable of being contained at a high content, and this enables the production of a resin molded article (for example, a sheet) having high heat conductivity.

<Component (A), two-component addition reaction type liquid silicone>

The two-component addition reaction type liquid silicone as the component (A) contains component (a1), an organopolysiloxane having a vinyl group at least at an end or on a side chain (hereinafter also called "organopolysiloxane having a vinyl group"), and component (a2), an organopolysiloxane having two or more H-Si groups at least at an end or on a side chain (hereinafter also called "organopolysiloxane having an H-Si group"). The component (A) preferably has a viscosity of 100 to 2,500 mPa·s at 25°C.

The component (a1) is an organopolysiloxane having a vinyl group at least at any position of the ends and the side chains and has a linear structure or a branched structure. Typically, the organopolysiloxane having a vinyl group has a structure in which some R moieties of the intermolecular (Si-R) groups in an organopolysiloxane are replaced by a vinyl group (for example, see General Formulae (a1-1) to (a1-4) shown later).

The vinyl group content in the component (a1) is preferably 0.01 to 15% by mole and is more preferably 0.01 to 5% by mole in the component (a1).

The organopolysiloxane having a vinyl group as the component (a1) is preferably an alkylpolysiloxane having a vinyl group. The alkyl group preferably has a carbon number of 1 to 3 (such as a methyl group and an ethyl group), and a methyl group is more preferred.

The organopolysiloxane having a vinyl group as the component (a1) preferably has a weight average molecular weight of less than 400,000, more preferably 10,000 to 200,000, and even more preferably 15,000 to 200,000.

In the present invention, the "vinyl group content" means % by mole of a vinyl group-containing siloxane unit relative to 100% by mole of the whole units in the component (a1). Provided that a single vinyl group-containing siloxane unit has a single vinyl group.

<Measurement method of vinyl group content>

The vinyl group content is determined by NMR. Specifically, a sample is dissolved in deuterated chloroform as a deuterated solvent, and the content is determined by using ECP-300NMR manufactured by JEOL. The vinyl group content (% by mole) is calculated as the vinyl group proportion where (vinyl group + H-Si group + Si-methyl group) is 100% by mole.

The component (a2) is an organopolysiloxane having two or more H-Si groups at least at any positions of the ends and the side chains and has a linear structure or a branched structure. Typically, the organopolysiloxane having an H-Si group has a structure in which some R moieties of the intermolecular (Si-R) groups in an organopolysiloxane are replaced by an H group (for example, see General Formulae (a2-1) to (a2-4) shown later).

The H-Si group content in the component (a2) is preferably 0.01 to 15% by mole and is more preferably 0.01 to 5% by mole in the component (a2).

The organopolysiloxane as the component (a2) is preferably an alkylpolysiloxane having an H-Si group. The alkyl group preferably has a carbon number of 1 to 3 (such as a methyl group and an ethyl group), and a methyl group is more preferred.

The organopolysiloxane having an H-Si group as the component (a2) preferably has a weight average molecular weight of 400,000 or less, more preferably 10,000 to 200,000, and even more preferably 15,000 to 200,000.

In the present invention, the "H-Si group content" means % by mole of an H-Si group-containing siloxane unit relative to 100% by mole of the whole units in the component (a2).

The content ratio of (a1) to (a2) in terms of mass ratio is preferably (a1):(a2) = 20 to 80:20 to 80, more preferably 40 to 60:40 to 60, and most preferably (a1):(a2) = 50:50.

<Measurement method of H-Si group content>

The H-Si group content is determined by NMR. A sample is dissolved in deuterated chloroform as a deuterated solvent, and the content is determined by using ECP-300NMR manufactured by JEOL. The H-Si group content (% by mole) is calculated as the H-Si group proportion where (vinyl group + H-Si group + Si-methyl group) is 100% by mole.

The two-component addition reaction type liquid silicone as the component (A) has a viscosity at 25°C of 100 to 2,500 mPa·s, preferably 100 to 2,000 mPa·s, and more preferably 350 to 2,000 mPa·s.

The component (A) having a viscosity (25°C) of 100 mPa·s or more has a large molecular weight, and this may prevent a cured sheet from breaking. When the component (A) has a viscosity of 2,500 mPa·s or less, the inorganic filler is easily contained at a high content. Hence, such conditions have advantages.

<Viscosity measurement>

The viscosity of the two-component addition type silicone was determined by using a Brookfield viscometer "RVDVIT" manufactured by BROOKFIELD. An f shaft may be used as the spindle to determine the viscosity at 20 rpm.

The two-component addition reaction type liquid silicone as the component (A) is preferably a heat curable type of the organopolysiloxanes, and in addition to a polyorganopolysiloxane polymer as the main agent, a curing agent (a crosslinkable organopolysiloxane) may be used.

The base polymer constituting the two-component addition reaction type liquid silicone preferably has an organic group (such as a methyl group, a phenyl group, and a trifluoropropyl group) on the main chain. Examples of the repeating structure of the organopolysiloxane include a dimethylsiloxane unit, phenylmethylsiloxane unit, and a diphenylsiloxane unit. A modified organopolysiloxane having a functional group such as a vinyl group and an epoxy group may be used.

The two-component addition reaction type liquid silicone as the component (A) may contain an addition reaction catalyst for accelerating addition reaction.

The two-component addition reaction type liquid silicone as the component (A) may be a commercial product satisfying the above various conditions.

Examples of the end or side chain vinyl group of the component (a1) include those represented by General Formula (a1-1) and General Formula (a1-2). Examples of the organopolysiloxane having a vinyl group at least at an end or on a side chain as the component (a1) include those represented by General Formula (a1-3) and General Formula (a1-4). The present invention is not intended to be limited to those of General Formulae (a1-1) to (a1-4). Examples of the component (a1) of the present invention include methylpolysiloxanes having a vinyl group at an end and/or on a side chain. Each of m and n is preferably a positive number.

[Chemical Formula 1]

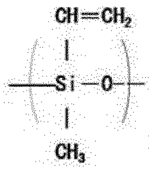 (a1-1) 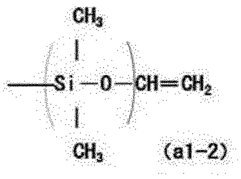 (a1-2)

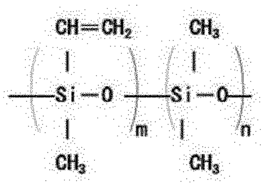 (a1-3) , 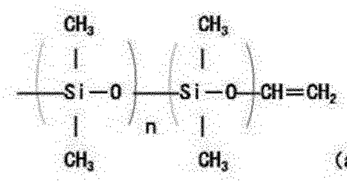 (a1-4)

Examples of the end or side chain H-Si group of the component (a2) include those represented by General Formula (a2-1) and General Formula (a2-2). Examples of the organopolysiloxane having two or more H-Si groups at least at an end or on a side chain as the component (a2) include those represented by General Formula (a2-3) and General Formula (a2-4). The present invention is not intended to be limited to those of General Formulae (a2-1) to (a2-4). Examples of the component (a2) of the present invention include methylpolysiloxanes having two or more H-Si groups at an end and/or on a side chain. Each of m and n is preferably a positive number.

[Chemical Formula 2]

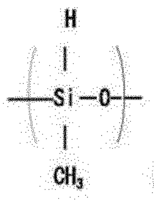 (a2-1) 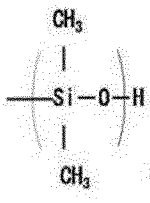 (a2-2)

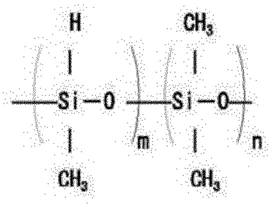 (a2-3) , 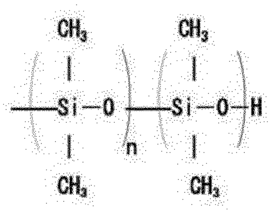 (a2-4)

Examples of the commercially available two-component addition reaction type liquid silicone rubber include "TSE-3062" and "X14-B8530" manufactured by Momentive and "SE-1885A/B" manufactured by Dow Corning Toray Co., Ltd. The present invention is not intended to be limited to those specific commercial products.
The content of the resin composition is preferably 10 to 65% by volume and more preferably 15 to 60% by volume relative to the total volume.
The content of the two-component addition reaction type liquid silicone as the component (A) is preferably 10 to 65% by volume and more preferably 15 to 60% by volume relative to the total volume. The lower limit of the content of the component (A) is more preferably 15% by volume or more. The upper limit of the content of the component (A) is more preferably 65% by volume or less.
When the content of the component (A) is 10% by volume or more in the heat-conductive composition, a resulting product obtains higher flexibility. When the content is 65% by volume or less in the heat-conductive composition, a reduction in the heat conductivity is likely to be prevented. Hence, such a condition has advantages.
The addition reaction type liquid silicone used in the present invention may be used in combination with a retardant such as acetyl alcohols and maleic acid esters, a thickener such as Aerosil and a silicone powder having a size of ten to hundreds of micrometers, a flame retardant, a pigment, and the like.

<Component (B), inorganic filler>

The content of the heat-conductive filler in the resin composition is preferably 35% by volume or more and more preferably 40 to 85% by volume relative to the total volume.

A resin composition containing the heat-conductive filler at a content of 35% by volume or more is likely to prevent a cured sheet from having insufficient heat conductivity, and thus a higher content is preferred. When the content is 85% by volume or less, the resin composition is unlikely to have poor flowability, and a cured product having a thickness of 0.3 mm or more is easily produced from the resin composition.

Examples of the inorganic filler used in the present invention include heat-conductive fillers such as aluminum oxide, magnesium oxide, boron nitride, aluminum nitride, silicon nitride, silicon carbide, metallic aluminum, and graphite. These fillers may be used singly or in combination of two or more of them. The inorganic filler used in the present invention is preferably a spherical type (preferably having a sphericity of 0.85 or more).

Specifically, aluminum oxide, which exhibits high heat conductivity and satisfactory packing property in a resin, is preferred.

The aluminum oxide used in the present invention is preferably spherical. Aluminum oxide (hereinafter also called "alumina") may be produced by any method of flame spraying of aluminum hydroxide powder, Bayer process, ammonium alum thermal decomposition method, organic aluminum hydrolysis method, aluminum underwater discharge method, and freeze drying. From the viewpoint of particle size distribution control and particle shape control, flame spraying of aluminum hydroxide powder is preferred.

The crystal structure of the spherical alumina powder may be a single crystal or a polycrystal, and the crystal phase is preferably an $\alpha$ phase from the viewpoint of high heat conductivity. The specific gravity is preferably 3.7 or more. If the specific gravity is less than 3.7, the particles contains pores and a low crystal phase at high contents, and hence the specific gravity is preferably 3.7 or more in order to increase the heat conductivity to more than 2.5 W/mK. The particle size of the spherical alumina powder may be controlled by classification/mixing operations of the spherical alumina powder.

When the spherical alumina powder is used, the sphericity is 0.85 or more. If having a sphericity of less than 0.85, the filler has poor flowability to segregate in a spacer, and physical properties greatly vary. Examples of the commercial product having a sphericity of 0.85 or more include spherical alumina DAW45S (trade name), spherical alumina DAW05 (trade name), and spherical alumina ASFP20 (trade name) manufactured by Denka Co. Ltd.

As for the particle size distribution of the inorganic filler of the present invention, inorganic fillers having a maximum value or a peak value in ranges of an average particle size of 10 to 100 $\mu$m, 1 to 10 $\mu$m, and less than 1 $\mu$m are preferred.

The inorganic filler having an average particle size of 10 to 100 $\mu$m is preferably contained at 15% by volume or more and more preferably at 20 to 50% by volume relative to the total volume.

The inorganic filler having an average particle size of 1 to 10 $\mu$m is preferably contained at 10 to 30% by volume and more preferably at 12 to 30% by volume relative to the total volume.

The inorganic filler having an average particle size of less than 1.0 $\mu$m is preferably contained at 5 to 20% by volume and more preferably at 8 to 15% by volume relative to the total volume.

For the particle size distribution of the inorganic filler, preferably, these inorganic fillers having three average particle sizes are appropriately combined.

<Method for producing heat-conductive sheet (before cutting) and the like>

The heat-conductive sheet may be produced by a known production method. For example, the components (A) and (B) may be mixed to produce the sheet.

The heat-conductive sheet of the present invention is produced, for example, through a material mixing step, a molding step, and a vulcanization step. For the mixing, a mixer such as a roll mill, a kneader, and a Banbury mixer is used. The molding method is preferably doctor blade method, and an extrusion method, a pressing method, a calender roll method, or the like may be used depending on the viscosity of a resin. The vulcanization temperature is preferably 50 to 200°C, and the heat curing time is preferably 2 to 14 hours. At 50°C or more, vulcanization is sufficiently performed, and at 200°C or less, a spacer is prevented from partially deteriorating. Hence, such a condition has advantages.

Vulcanization is performed by using a common hot-air drier, a far-infrared dryer, a microwave dryer, or the like.

In this manner, a heat-conductive sheet may be prepared.

As the resin materials used in the present invention, a resin material such as an acrylic resin and an epoxy resin may be appropriately selected and used in addition to the components (A) and (B) as long as the advantageous effects of the present invention are not impaired. Such an additional resin material may be added so that the composition of the present invention will be 100% by volume or may be added to 100% by volume of the composition of the present invention.

The heat-conductive sheet of the present invention (before cutting) prepared from the resin composition preferably has a thickness of 0.3 to 10 mm. If the heat-conductive sheet of the present invention (before cutting) has a thickness of less than 0.3 mm, the surface roughness is likely to increase due to the heat-conductive filler, and the heat conductivity is likely to be reduced. Hence, the thickness is preferably 0.3 mm or more. If the thickness is more than 10 mm, the cured product of the resin molded article has a larger thickness, and the heat conductivity is likely to be reduced. Hence, the thickness is preferably 10 mm or less. The thickness of the heat-conductive sheet of the present invention (before cutting) is preferably based on the thickness of a resin composition after curing.

Use of the resin composition enables the production of a heat-conductive sheet (before cutting) and a heat generating sheet (before cutting) having high heat conductivity and high flexibility.

The heat-conductive sheet (before cutting) has high heat conductivity, and a sheet having a heat conductivity of 0.5 W/mK or more is provided.

The heat-conductive sheet of the present invention is characterized in that the surface of a heat-conductive sheet (before cutting) having high heat conductivity and high flexibility is subjected to a cutting process, and the sheet surface has cuts. The process is preferably so performed as to give a cut rate of 2 to 90% to the sheet thickness. The compressive stress (at a compressibility of 20%) of the sheet with cuts is preferably reduced by 5% or more as compared with a sheet having a surface without cuts.

A conventionally produced heat-conductive sheet practically has an Asker C hardness of at least about 40. However, when a product having a larger area is compressed, the stress markedly increases, and thus a larger stress may be applied to a heat-generating element or a substrate therewith. It is important to reduce the compressive stress so as not to apply a larger load than the Asker C hardness at the time of mounting.

In other words, use of the heat-conductive composition enables the production of a heat-conductive sheet (before cutting) having a small hardness and a high heat conductivity of 0.5 W/mK or more. Use of the heat-conductive composition enables the production of a heat-conductive sheet (after cutting) having a plurality of cuts on a sheet face and having a compressive stress that is 5% or more smaller than that without cutting. Use of the heat-conductive composition enables the production of a heat-conductive sheet (after cutting) having a plurality of cuts and having a higher following property to a member.

Use of the heat-conductive composition enables the production of a heat-conductive sheet (before cutting) having an Asker C hardness of 5 to 40, which indicates high flexibility to particularly reduce the compressive stress.

In other words, the heat-conductive sheet (before cutting) prepared from the heat-conductive composition is suitable for the sheet before processing for the heat-conductive sheet having a plurality of cuts of the present invention.

The method for producing the heat-conductive sheet having a plurality of cuts of the present invention is characterized by performing such a process of forming a plurality of cuts as above and is also a production method of a heat-conductive sheet before cutting (for example, a heat dissipation material) that does not have the above Asker C hardness but is capable of exerting substantially the same effect.

Example embodiments in the present invention will be described with reference to Fig. 1 to Fig. 3. The present invention is not intended to be limited to the embodiments.

As shown in Fig. 1, a heat-conductive sheet 1 of the present embodiment has a plurality of cuts 2 by subjecting a sheet face to be in contact with a member to a cutting process in the transverse direction and the longitudinal direction so as to give a grid pattern.

By the cutting process, the heat-conductive sheet 1 of the present embodiment has the cuts 2 with a cut depth 4 in the vertical direction. The cut depth 4 does not reach the thickness 3 of the sheet, and the cuts 2 do not penetrate the sheet in the vertical direction. Faces in the vertical direction formed by the cuts 2 in the transverse direction and the longitudinal direction are at least partly in contact with each other. The vertical cross-sectional shape of each cut 2 has an I-shape.

The heat-conductive sheet 1 of the present embodiment has a plurality of sections 6 formed by the cutting process in the transverse direction and the longitudinal direction, and each sections 6 has a square (regular square) shape. A side of each section 6 is an interval 5 of cuts 2 adjacent in the transverse direction, and another side is an interval 5 of cuts 2 adjacent in the longitudinal direction.

The heat-conductive sheet 1 of the present embodiment is produced by subjecting a heat-conductive sheet formed from a composition comprising a silicone resin composition and an inorganic filler to a slitting process with a cutter.

As shown in Fig. 2, the heat-conductive sheet 1 of the present embodiment is used in an electronic member 10. The electronic member 10 of the present embodiment comprises the heat-conductive sheet 1 of the present embodiment, a heat-generating member 11 with a heat-generating semiconductor element, and a cooling member 12 such as a radiation fin. The heat-conductive sheet 1 of the present embodiment is interposed between the heat-generating member 11 and the cooling member 12 under a load.

The sheet face having a plurality of cuts in the heat-conductive sheet 1 of the present embodiment is in contact with the heat-generating member 11. The heat-conductive sheet 1 of the present embodiment has high flexibility and a cut structure and thus has high following property to the contact face of the heat-generating member 11. The heat-conductive sheet 1 of the present embodiment has high following property and high flexibility and thus is in contact with such a member without damages.

The heat-conductive sheet 1 of the present embodiment has high heat conductivity, high flexibility, and high following property, thus is capable of efficiently transferring heat from the heat-generating member 11 to the cooling member 12, and efficiently dissipates heat from the heat-generating member 11.

The electronic member 10 comprising the heat-conductive sheet 1 of the present embodiment may be provided as an electronic component capable of suppressing a shorter lifetime, malfunctions, or failures of the electronic component due to a temperature increase, distortion of a casing, or the like.

The heat-conductive sheet of the present invention may be a heat-conductive sheet 1b as shown in Fig. 3, and the electronic member of the present invention may be an electronic member 10b comprising the heat-conductive sheet 1b. The heat-conductive sheet 1b of the present embodiment has, on a surface thereof, a plurality of italic I-shapes with an angle as cuts 2b. The heat-conductive sheet 1b of the present embodiment has high heat conductivity, high flexibility, and high following property, thus is capable of efficiently transferring heat from the heat-generating member 11 to the cooling member 12, and efficiently dissipates heat from the heat-generating member 11. The electronic member 10b comprising the heat-conductive sheet 1b of the present embodiment may be provided as an electronic component capable of suppressing a shorter lifetime, malfunctions, or failures of the electronic component due to a temperature increase, distortion of a casing, or the like.

In Fig. 3 used for explanation, the vertical cross-sectional shape of each cut is an "italic I-shape tilted to the left" formed by cutting the heat-conductive sheet surface obliquely from the left direction, but the cutting direction is not specifically limited. Cutting may be performed obliquely from the right direction at an angle or may be performed obliquely from the left direction at an angle. The vertical cross-sectional shape of the cut may be a mixture of "italic I-shapes tilted to the left" and "italic I-shapes tilted to the right" in the heat-conductive sheet.

As described above, the present invention enables the production of a heat-conductive sheet having high heat conductivity and high flexibility and also having high following property to a member. The heat-conductive sheet of the present invention has cuts in place of grooves, thus does not hold air, and also has high following property to a member to achieve high adhesiveness to the member, resulting in high heat dissipation property. The present invention also enables the production of a heat generating electronic component comprising the heat-conductive sheet of the present invention, a heat-dissipating member and a heat dissipation component, an electronic member and an electronic component, and the like and of a product relating thereto.

The present invention further enables the production of a heat-conductive heat-dissipating sheet having high heat conductivity and high flexibility and also having high following property. More preferably, the present invention enables the production of a heat-dissipating spacer, and the heat-dissipating spacer is particularly preferred as a heat-dissipating member for an electronic component.

The heat-conductive sheet of the present invention is preferably used as such a heat-dissipating member for an electronic component as to be required to have adhesiveness between a heat-generating face of a semiconductor element and a heat-dissipating face of a radiation fin. The heat-dissipating member of the present invention is preferably used as, for example, a heat-dissipating sheet and a heat-dissipating spacer.

The heat-conductive sheet and the heat-dissipating member of the present invention have high flexibility and excellent adhesiveness to a heat-generating element and thus is applicable to an electronic device (for example, a smartphone, a tablet PC, a personal computer, a home game machine, a power supply, and an automobile) and also applicable to, for example, a wireless base station.

The spacer of the present invention is produced through a material mixing step, a molding step, and a vulcanization step. For the mixing, a mixer such as a roll mill, a kneader, and a Banbury mixer is used. The molding method is preferably doctor blade method, and an extrusion method, a pressing method, a calender roll method, or the like may be used depending on the viscosity of a heat-conductive composition. The vulcanization temperature is preferably 50 to 200°C. At less than 50°C, vulcanization is insufficient, and at more than 200°C, a spacer partially deteriorates. Vulcanization is performed by using a common hot-air drier, a far-infrared dryer, a microwave dryer, or the like. In this manner, a heat-conductive sheet is produced.

The cutting method may be any of slitting processes with a cutter and processing with a laser knife and enables the formation of a cut having 2 to 90% length of the thickness.

The present invention is suitably used for a heat-conductive member in industrial members and the like and is particularly suitably used for a high heat-conductive sheet and a heat-dissipating member having a small compressive stress at the time of mounting and having high flexibility.

The heat-conductive sheet of the present invention has cuts but holds the sheet shape.

## Examples

The present invention will next be described in detail with reference to test examples, examples, and comparative

examples. The present invention is not intended to be limited to the following examples.

The component (A), a two-component addition reaction type silicone comprising (a1: an organopolysiloxane having a vinyl group) + (a2: an organopolysiloxane having an H-Si group), and the component (B), inorganic fillers, shown below were mixed in accordance with the formulation (% by volume) for each test example in Tables 1 to 4 to give a composition. The total amount of the component (A) and the component (B) was 100% in terms of volume.

The mixed composition was used to prepare a sheet (resin molded article) having a predetermined thickness by doctor blading, and the sheet was thermally cured at 110°C for 8 hours. Consequently, various heat-conductive sheets of Test Examples 1 to 45 were produced.

The compositions, cutting conditions, and evaluation results of Test Examples 1 to 37 are shown in Tables 1 to 4.

To form a grid pattern by a cutting process, a cutting blade was used to form linear cuts on a heat-conductive sheet in the longitudinal direction and the transverse direction. The cutting process formed a plurality of sections, and each section had a square shape.

To form a diamond shape (an isosceles triangular shape, 1.5 mm for two sides) by a cutting process, a cutting blade was used to form linear cuts based on the diagonal lines of a sheet. The cutting process formed a plurality of sections, and each section had a diamond shape.

To form a star shape or a circular shape by a cutting process, a cutting die corresponding thereto was pushed downward to form cuts having an intended pattern. The cutting process formed a plurality of sections, and each section had a star shape or a circular shape.

The slit formed by the cutting (the clearance of the cut portion) appears just as a trace and has a clearance of 50 μm or less. In the slit, cut faces formed by the cutting process are in contact with each other.

The cut depth, the uncut depth, and the grid size (the length of one side or the diameter, hereinafter also called interval between cuts) are each the average length from a sheet face or on a sheet face.

In Test Examples 1 to 6, Test Examples 7 to 9, Test Examples 17 to 20, and Test Examples 23 to 26, a composition comprising the components (A) and (B) was used to prepare a sheet, and cuts were formed on the sheet surface in a sheet thickness range of 0.3 to 10 mm to produce a heat-conductive heat-dissipating sheet having flexibility and having a compressive stress that was 5% or more smaller than that of the sheet without cuts. When the cut rate was 2 to 90%, a heat-conductive heat-dissipating sheet having a compressive stress reduction effect was produced.

In Test Examples 1 to 37, each heat-dissipating sheet had a slit shape but satisfactory held the shape (o).

In Test Examples 10 to 16 and Test Examples 17 to 20, a composition comprising the components (A) and (B) was used to prepare a sheet, and cuts were formed on the sheet surface to produce a heat-conductive heat-dissipating sheet having flexibility and having a compressive stress that was 5% or more smaller than that of the sheet without cuts. When the cut interval was 0.5 to 5.0 mm, a heat-conductive heat-dissipating sheet having a compressive stress reduction effect was produced.

In Test Examples 21 to 26, a composition comprising the components (A) and (B) was used to prepare a sheet, and cuts having various shapes including a square shape, a triangular shape, and a circular shape were formed on the sheet surface to produce a heat-conductive heat-dissipating sheet having flexibility and having a compressive stress that was 5% or more smaller than that of the sheet without cuts. In Test Examples 27 to 29, cuts were formed on one face or both faces of the sheet to produce a heat-conductive heat-dissipating sheet having flexibility and having a compressive stress that was 5% or more smaller than that of the sheet without cuts.

In Test Examples 30 to 37, a composition comprising the component (A) and the component (B) in which the molecular weight of the silicone resin as the component (A) was changed and the amounts of the heat-conductive fillers as the component (B) were changed was used to prepare a sheet, and cuts were formed on the sheet surface to produce a heat-conductive heat-dissipating sheet having flexibility and having a compressive stress that was 5% or more smaller than that of the sheet without cuts.

The materials used for the production of the heat-conductive compositions are shown below.

[Component (A), two-component addition reaction type silicone]

<A-1>

Two-component addition reaction type silicone (an organopolysiloxane having a vinyl group and a methyl group (a vinyl group content of 0.3% by mole):an organopolysiloxane having an H-Si group and a methyl group (an H-Si content of 0.5% by mole) = (a1) 1:(a2) 1 (mass ratio)); SE-1885 manufactured by Dow Corning Toray Co., Ltd.; a viscosity of 430 mPa·sec; each organopolysiloxane had a weight average molecular weight of 120,000.

<A-2>

Two-component addition reaction type silicone (an organopolysiloxane having a vinyl group and a methyl group

(a vinyl group content of 0.8% by mole):an organopolysiloxane having an H-Si group and a methyl group (an H-Si content of 1.0% by mole) = (a1) 1:(a2) 1 (mass ratio)); TSE-3062 manufactured by Momentive; a viscosity of 1,000 mPa·sec; each organopolysiloxane had a weight average molecular weight of 25,000.

<A-3>

Two-component addition reaction type silicone (an organopolysiloxane having a vinyl group and a methyl group (a vinyl group content of 0.8% by mole):an organopolysiloxane having an H-Si group and a methyl group (an H-Si content of 1.0% by mole) = (a1) 1:(a2) 1 (mass ratio)); X14-B8530 manufactured by Momentive; a viscosity of 350 mPa·sec; each organopolysiloxane had a weight average molecular weight of 21,000.

[Component (B), inorganic filler]

As the inorganic filler, the following aluminum oxides were used. In Tables, the content (% by volume) of the inorganic filler is the total amount of the used spherical fillers and crystalline alumina.
Filler d50: 45 μm: spherical alumina DAW45S manufactured by Denka Co. Ltd.
Filler d50: 5 μm: spherical alumina DAW05 manufactured by Denka Co. Ltd.
As the crystalline alumina powder, the following crystalline alumina was used.
d50: 0.5 μm: crystalline alumina AA-05 manufactured by Sumitomo Chemical Co., Ltd.

[Evaluation criteria]

Evaluation was performed on the basis of the following criteria.
[Heat conductivity] A sample having a heat conductivity of 0.5 W/mK or more is good; a sample having a heat conductivity of 2 W/mK or more is better; and a sample having a heat conductivity of 4W/mK or more is excellent.
[Heat resistance] A sample having a heat resistance of 20°C/W or less is good; and a sample having a heat resistance of 10°C/W or less is excellent.
[Reduction rate of compressive stress] A sample having a reduction rate of 5% or more is good.
[Asker C hardness] A sample having an Asker C hardness of less than 40 has good flexibility; and a sample having an Asker C hardness of 15 or less has excellent flexibility.
[Shape holding] A heat-conductive sheet was placed on a position that required heat dissipation of an electronic device. After placement, the shape of the heat-conductive sheet was visually observed. A markedly deformed sheet is evaluated as poor shape holding property (×); and a slightly deformed sheet is evaluated as good shape holding property (o).

<Heat resistance>

The above-obtained heat-conductive sheet was cut into a TO-3 shape and subjected to heat resistance measurement.
To determine the heat resistance, a sample cut into a TO-3 shape was interposed between a TO-3 type copper heater case (an effective area of 6.0 $cm^2$) having a transistor therein and a copper plate, and the sample was set under a load so that the initial thickness was reduced by 10%. To the transistor, an electric power of 15 W was applied for 5 minutes, and the heat resistance was calculated from the temperature difference (°C) between the heater case and the radiation fin in accordance with Equation (1).

Equation (1): "heat resistance (°C/W) = (heater side temperature (°C) - cooler side temperature (°C)/electric power (W)" was used for calculation.

<Heat conductivity>

The heat conductivity was calculated from the above heat resistance in accordance with Equation (2): "heat conductivity (W/mK) = thickness (m)/(cross-sectional area ($m^2$) × heat resistance (°C/W))".

<Asker C hardness>

The hardness of the heat-conductive sheet used in the present invention may be determined by using an Asker

C type spring hardness meter in accordance with SRIS0101 at 25°C. The Asker C hardness may be determined by using "ASKER Durometer Type C" manufactured by KOBUNSHI KEIKI CO., LTD. The cured silicone resins had a type C Asker C hardness of not less than 5 and less than 40. A sheet having a type C hardness of not less than 5 has satisfactory handling properties when the sheet is handled.

<Compressive stress>

The compressive stress in the present invention was determined as follows: a heat-conductive sheet was punched into a 60 × 60-mm piece, and then the load N was determined by using a Table-Top Tester (EZ-LX manufactured by Shimadzu Corporation) at a compressibility of 20% or a compressibility of 50% relative to the thickness. The load N at a compressibility of 5% was also determined in a similar manner.

The compressibility was calculated in accordance with compressibility (%) = {compressive deformation (mm) × 100}/original thickness (mm).

<Weight average molecular weight>

The weight average molecular weights of polyorganosiloxanes and silicones were determined from the result of gel permeation chromatographic analysis in terms of polystyrene. Separation was performed by a nonaqueous porous gel (polystyrene-dimethylbenzene copolymer) with toluene as the mobile phase where a differential refractometer (RI) was used as the detector.

<Average particle size, largest particle size, maximum value>

The average particle size, the largest particle size, and the maximum value of an inorganic filler were determined by using a "Laser diffraction particle size distribution analyzer SALD-20" manufactured by Shimadzu Corporation. To prepare a test sample, 50 cc of pure water and 5 g of an inorganic filler powder to be measured were placed in a glass beaker. The whole was stirred with a spatula and then was dispersed in an ultrasonic cleaner for 10 minutes. The dispersed liquid of the inorganic filler powder was added dropwise with a dropper to a sampler of the analyzer and was allowed to stand until the absorbance was measurable. After stabilization of the absorbance, the measurement was performed. By the laser diffraction particle size analyzer, a particle size distribution is calculated from light intensity distribution data of diffraction/scattering light by particles detected with a sensor. The average particle size is calculated as follows: the determined particle size is multiplied by a relative particle amount (difference %), and the product is divided by the total relative particle amount (100%). The average particle size is the average diameter of particles, and the maximum value may be calculated as a particle size (mode diameter) corresponding to the mode value in the particle size distribution. The largest value of the particle sizes in the determined particle size distribution may be considered as the largest particle size.

[Table 1]

| Test Example | 1 | 2 | 3 | 4 | 5 | 6 | 7 | 8 | 9 |
|---|---|---|---|---|---|---|---|---|---|
| Resin A-1 (SE1885) (% by volume) | 33 | 33 | 33 | 33 | 33 | 33 | 33 | 33 | 33 |
| Inorganic filler (% by volume) | 67 | 67 | 67 | 67 | 67 | 67 | 67 | 67 | 67 |
| Spherical filler d50: 45 mm | 34 | 34 | 34 | 34 | 34 | 34 | 34 | 34 | 34 |
| Spherical filler d50: 5 mm | 20 | 20 | 20 | 20 | 20 | 20 | 20 | 20 | 20 |
| Crystalline alumina d50: 0.5 mm | 13 | 13 | 13 | 13 | 13 | 13 | 13 | 13 | 13 |
| Heat conductivity (W/mK) | 3 | 3 | 3 | 3 | 3 | 3 | 3 | 3 | 3 |
| Cut rate (%) | 50 | 50 | 50 | 50 | 50 | 50 | 2 | 20 | 90 |
| Cut depth (mm) | 0.15 | 0.25 | 0.5 | 1.5 | 2.5 | 5 | 0.06 | 0.6 | 2.7 |
| Uncut length (mm) | 0.15 | 0.25 | 0.5 | 1.5 | 2.5 | 5 | 2.94 | 2.4 | 0.3 |
| Cut face | One side | One side | One side | One side | One side | One side | One side | One side | One side |

(continued)

| Test Example | | 1 | 2 | 3 | 4 | 5 | 6 | 7 | 8 | 9 |
|---|---|---|---|---|---|---|---|---|---|---|
| Cut shape | | Grid | Grid | Grid | Grid | Grid | Grid | Grid | Grid | Grid |
| Sample thickness (mm) | | 0.3 | 0.5 | 1 | 3 | 5 | 10 | 3 | 3 | 3 |
| Com pressibility | | ○ | ○ | ○ | ○ | ○ | ○ | ○ | ○ | ○ |
| Asker C | without cuts | 10 | 10 | 10 | 10 | 10 | 10 | 10 | 10 | 10 |
| | with cuts | 8 | 8 | 8 | 8 | 8 | 8 | 8 | 8 | 8 |
| Compressive stress (N) | without cuts | 8 | 14 | 30 | 226 | 175 | 84 | 226 | 226 | 226 |
| (at a compressibility of 20%) | after cutting | 6 | 9 | 20 | 200 | 129 | 70 | 214 | 210 | 150 |
| Reduction rate at a compressibility of 20% (%) | | 25.0 | 35.7 | 33.3 | 11.5 | 26.3 | 16.7 | 5.3 | 7.1 | 33.6 |
| Compressive stress (N) | without cuts | 30 | 360 | 695 | 1360 | 1520 | 950 | 1360 | 1360 | 1360 |
| (at a compressibility of 50%) | after cutting | 25 | 150 | 615 | 1190 | 1250 | 840 | 1250 | 1210 | 1000 |
| Reduction rate at a compressibility of 50% (%) | | 16.7 | 58.3 | 11.5 | 12.5 | 17.8 | 11.6 | 8.1 | 11.0 | 26.5 |
| Grid size (mm) | | 1.5 | 1.5 | 1.5 | 1.5 | 1.5 | 1.5 | 1.5 | 1.5 | 1.5 |
| Number of partitions/15 $mm^2$ | | 100 | 100 | 100 | 100 | 100 | 100 | 100 | 100 | 100 |
| Heat resistance (°C/W) | | 0.2 | 0.3 | 0.6 | 1.7 | 2.8 | 5.6 | 1.7 | 1.7 | 1.7 |
| Partitioned area ratio of a section (%) | | 1.0 | 1.0 | 1.0 | 1.0 | 1.0 | 1.0 | 1.0 | 1.0 | 1.0 |
| Shape holding | | ○ | ○ | ○ | ○ | ○ | ○ | ○ | ○ | ○ |

[Table 2]

| Test Example | | 10 | 11 | 12 | 13 | 14 | 15 | 16 | 17 | 18 | 19 | 20 |
|---|---|---|---|---|---|---|---|---|---|---|---|---|
| Resin A-1 (SE1885) (% by volume) | | 33 | 33 | 33 | 33 | 33 | 33 | 33 | 33 | 33 | 33 | 33 |
| Inorganic filler (% by volume) | | 67 | 67 | 67 | 67 | 67 | 67 | 67 | 67 | 67 | 67 | 67 |
| Spherical filler d50: 45 mm | | 34 | 34 | 34 | 34 | 34 | 34 | 34 | 34 | 34 | 34 | 34 |
| Spherical filler d50: 5 mm | | 20 | 20 | 20 | 20 | 20 | 20 | 20 | 20 | 20 | 20 | 20 |
| Crystalline alumina d50: 0.5 mm | | 13 | 13 | 13 | 13 | 13 | 13 | 13 | 13 | 13 | 13 | 13 |
| Heat conductivity (W/mK) | | 3 | 3 | 3 | 3 | 3 | 3 | 3 | 3 | 3 | 3 | 3 |
| Cut rate (%) | | 50 | 50 | 50 | 50 | 50 | 50 | 50 | 10 | 90 | 10 | 90 |
| Cut depth (mm) | | 1.5 | 1.5 | 1.5 | 1.5 | 1.5 | 1.5 | 1.5 | 0.3 | 2.7 | 0.6 | 5.4 |
| Uncut length (mm) | | 1.5 | 1.5 | 1.5 | 1.5 | 1.5 | 1.5 | 1.5 | 2.7 | 0.3 | 5.4 | 0.6 |
| Slit position | | One side | One side | One side | One side | One side | One side | One side | One side | One side | One side | One side |
| Slit shape | | Grid | Grid | Grid | Grid | Grid | Grid | Grid | Grid | Grid | Grid | Grid |
| Sample thickness (mm) | | 3 | 3 | 3 | 3 | 3 | 3 | 3 | 3 | 3 | 6 | 6 |
| Compressibility | | ○ | ○ | ○ | ○ | ○ | ○ | ○ | ○ | ○ | ○ | ○ |
| Asker C | without cuts | 10 | 10 | 10 | 10 | 10 | 10 | 10 | 10 | 10 | 10 | 10 |
| | with cuts | 6 | 6 | 6 | 7 | 7 | 7 | 7 | 8 | 5 | 8 | 5 |
| Compressive stress (N) | without cuts | 226 | 226 | 226 | 226 | 226 | 226 | 226 | 226 | 226 | 175 | 175 |
| (at a compressibility of 20%) | after cutting | 175 | 180 | 185 | 190 | 205 | 210 | 214 | 205 | 185 | 150 | 129 |
| Reduction rate at a compressibility of 20% (%) | | 22.6 | 20.4 | 18.1 | 15.9 | 9.3 | 7.1 | 5.3 | 9.3 | 18.1 | 14.3 | 26.3 |
| Compressive stress (N) | without cuts | 1360 | 1360 | 1360 | 1360 | 1360 | 1360 | 1360 | 1360 | 1360 | 1520 | 1520 |
| (at a compressibility of 50%) | after cutting | 1070 | 1100 | 1180 | 1200 | 1270 | 1270 | 1280 | 1260 | 1080 | 1410 | 1250 |
| Reduction rate at a compressibility of 50% (%) | | 21.3 | 19.1 | 13.2 | 11.8 | 6.6 | 6.6 | 5.9 | 7.4 | 20.6 | 7.2 | 17.8 |
| Grid size (mm) | | 0.5 | 0.75 | 1 | 2.14 | 2.5 | 3.75 | 5 | 0.75 | 0.75 | 5 | 5 |
| Number of partitions/15 $mm^2$ | | 900 | 400 | 225 | 49 | 36 | 16 | 9 | 400 | 400 | 9 | 9 |
| Heat resistance (°C/W) | | 1.7 | 1.7 | 1.7 | 1.7 | 1.7 | 1.7 | 1.7 | 1.7 | 1.7 | 3.3 | 3.3 |

(continued)

| Test Example | 10 | 11 | 12 | 13 | 14 | 15 | 16 | 17 | 18 | 19 | 20 |
|---|---|---|---|---|---|---|---|---|---|---|---|
| Partitioned area ratio of a section (%) | 0.3 | 0.3 | 0.4 | 2.0 | 2.8 | 6.3 | 11.1 | 0.3 | 0.3 | 11.1 | 11.1 |
| Shape holding | ○ | ○ | ○ | ○ | ○ | ○ | ○ | ○ | ○ | ○ | ○ |

[Table 3]

| Test Example | 21 | 22 | 23 | 24 | 25 | 26 | 27 | 28 | 29 |
|---|---|---|---|---|---|---|---|---|---|
| Resin A-1 (SE1885) (% by volume) | 33 | 33 | 60 | 60 | 15 | 15 | 33 | 33 | 33 |
| Inorganic filler (% by volume) | 67 | 67 | 40 | 40 | 85 | 85 | 67 | 67 | 67 |
| Spherical filler d50: 45 mm | 34 | 34 | 20 | 20 | 47 | 47 | 34 | 34 | 34 |
| Spherical filler d50: 5 mm | 20 | 20 | 12 | 12 | 25 | 25 | 20 | 20 | 20 |
| Crystalline alumina d50: 0.5 mm | 13 | 13 | 8 | 8 | 13 | 13 | 13 | 13 | 13 |
| Heat conductivity (W/mK) | 3.0 | 3.0 | 0.5 | 0.5 | 7.0 | 7.0 | 3.0 | 3.0 | 3.0 |
| Cut rate (%) | 50 | 50 | 50 | 50 | 50 | 50 | 10 | 50 | 90 |
| Cut depth (mm) | 1.5 | 1.5 | 0.15 | 3 | 0.15 | 3 | 0.15 | 0.75 | 1.35 |
| Uncut length (mm) | 1.5 | 1.5 | 0.15 | 3 | 0.15 | 3 | 2.7 | 1.5 | 0.3 |
| Slit position | One side | One side | One side | One side | One side | One side | Both faces | Both faces | Both faces |
| Slit shape | Triangular shape | Circular shape | Grid | Grid | Grid | Grid | Grid | Grid | Grid |
| Sample thickness (mm) | 3 | 3 | 0.3 | 6 | 0 | 6 | 3 | 3 | 3 |
| Com pressibility | ○ | ○ | ○ | ○ | ○ | ○ | ○ | ○ | ○ |
| Asker C without cuts | 10 | 10 | 9 | 9 | 16 | 16 | 10 | 10 | 10 |
| with cuts | 8 | 8 | 7 | 6 | 14 | 12 | 8 | 8 | 8 |
| Compressive stress (N) without cuts | 226 | 226 | 120 | 320 | 240 | 600 | 226 | 226 | 226 |
| (at a compressibility of 20%) after cutting | 200 | 203 | 105 | 285 | 210 | 530 | 210 | 195 | 100 |
| Reduction rate at a compressibility of 20% (%) | 11.5 | 10.2 | 12.5 | 10.9 | 12.5 | 11.7 | 7.1 | 13.7 | 55.8 |
| Compressive stress (N) without cuts | 1360 | 1360 | 1100 | 2150 | 2500 | 3700 | 1360 | 1360 | 1360 |
| (at a compressibility of 50%) after cutting | 1210 | 1230 | 990 | 1930 | 2250 | 3300 | 1210 | 1200 | 1180 |
| Reduction rate at a compressibility of 50% (%) | 11.0 | 9.6 | 10.0 | 10.2 | 10.0 | 10.8 | 11.0 | 11.8 | 13.2 |
| Grid size (mm) | 1.5 | 1.5 | 1.5 | 1.5 | 1.5 | 1.5 | 1.5 | 1.5 | 1.5 |
| Number of partitions/15 $mm^2$ | 200 | 100 | 100 | 100 | 100 | 100 | 100 | 100 | 100 |
| Heat resistance (°C/W) | 1.7 | 1.7 | 1.0 | 20.0 | 0.07 | 1.4 | 1.7 | 1.7 | 1.7 |

(continued)

| Test Example | 21 | 22 | 23 | 24 | 25 | 26 | 27 | 28 | 29 |
|---|---|---|---|---|---|---|---|---|---|
| Partitioned area ratio of a section (%) | 0.5 | 1.0 | 1.0 | 1.0 | 1.0 | 1.0 | 1.0 | 1.0 | 1.0 |
| Shape holding | ○ | ○ | ○ | ○ | ○ | ○ | ○ | ○ | ○ |

[Table 4]

| Test Example | | 30 | 31 | 32 | 33 | 34 | 35 | 36 | 37 |
|---|---|---|---|---|---|---|---|---|---|
| Resin A-2 (TSE3062) (%) | | 33 | 33 | 33 | 33 | - | - | - | - |
| Inorganic filler (%) | | 67 | 67 | 67 | 67 | - | - | - | - |
| Resin A-3 (X14-B8530) (%) | | - | - | - | - | 60 | 60 | 15 | 15 |
| Inorganic filler (%) | | - | - | - | - | 40 | 40 | 85 | 85 |
| Spherical filler d50: 45 mm | | 34 | 34 | 34 | 34 | 20 | 20 | 47 | 47 |
| Spherical filler d50: 5 mm | | 20 | 20 | 20 | 20 | 12 | 12 | 25 | 25 |
| Crystalline alumina d50: 0.5 mm | | 13 | 13 | 13 | 13 | 8 | 8 | 13 | 13 |
| Heat conductivity (W/mK) | | 3 | 3 | 3 | 3 | 1 | 1 | 7 | 7 |
| Cut rate (%) | | 50 | 50 | 50 | 50 | 50 | 50 | 50 | 50 |
| Cut depth (mm) | | 0.15 | 0.5 | 2.5 | 5.0 | 0.5 | 2.5 | 0.5 | 2.5 |
| Uncut length (mm) | | 0.15 | 0.5 | 2.5 | 5.0 | 0.5 | 2.5 | 0.5 | 2.5 |
| Slit position | | One side | One side | One side | One side | One side | One side | One side | One side |
| Slit shape | | Grid | Grid | Grid | Grid | Grid | Grid | Grid | Grid |
| Sample thickness (mm) | | 0.3 | 1 | 5 | 10 | 1 | 5 | 1 | 5 |
| Compressibility | | ○ | ○ | ○ | ○ | ○ | ○ | ○ | ○ |
| Asker C | without cuts | 30 | 30 | 30 | 30 | 20 | 20 | 36 | 36 |
| | with cuts | 28 | 28 | 28 | 24 | 18 | 17 | 34 | 32 |
| Compressive stress (N) | without cuts | 15 | 192 | 460 | 300 | 100 | 300 | 210 | 550 |
| (at a compressibility of 20%) | after cutting | 12 | 177 | 400 | 274 | 85 | 265 | 190 | 490 |
| Reduction rate at a compressibility of 20% (%) | | 20.0 | 7.8 | 13.0 | 8.7 | 15.0 | 11.7 | 9.5 | 10.9 |
| Compressive stress (N) | without cuts | 250 | 2000 | 3350 | 3050 | 950 | 2000 | 2400 | 3600 |
| (at a compressibility of 50%) | after cutting | 205 | 1850 | 2650 | 2700 | 800 | 1780 | 2100 | 2800 |
| Reduction rate at a compressibility of 50% (%) | | 18.0 | 7.5 | 20.9 | 11.5 | 15.8 | 11.0 | 12.5 | 22.2 |
| Grid size (mm) | | 1.5 | 1.5 | 1.5 | 1.5 | 1.5 | 1.5 | 1.5 | 1.5 |
| Number of partitions/15 $mm^2$ | | 100 | 100 | 100 | 100 | 100 | 100 | 100 | 100 |
| Heat resistance (°C/W) | | 0.2 | 0.6 | 2.8 | 5.6 | 3.3 | 16.6 | 0.2 | 1.2 |
| Partitioned area ratio of a section (%) | | 1.0 | 1.0 | 1.0 | 1.0 | 1.0 | 1.0 | 1.0 | 1.0 |
| Shape holding | | ○ | ○ | ○ | ○ | ○ | ○ | ○ | ○ |

Process conditions and evaluation results in Test Examples 38 to 45 are shown in Table 5.

As the heater, HP-1SA manufactured by As One Corporation was used, and as the temperature measurement device, FLIRi5 manufactured by CHINO was used for temperature measurement.

<Heat-conductive sheet>

To specifically determine the following property, the test shown below was performed. The heat-conductive sheet to be used was prepared as follows: the composition used in Test Example 1 was used to prepare uncut heat-conductive sheets having various thicknesses in accordance with the sheet production method in Test Example 1.

One face of the uncut sheet was subjected to a slitting process, giving heat-conductive heat-dissipating spacers of Test Examples 41 to 45 (Examples). The cut depth ratio was 50%, the interval between cuts was 1.5 mm, and the section formed by cuts had a square shape.

As Comparative Examples, one face of the uncut sheet was subjected to a grooving process (1.5 mm), giving heat-conductive sheets of Test Examples 38 to 40. The groove depth ratio was 50%.

<Convex portion test/concave portion test>

On a face of a heat-generating element, a convex portion and a concave portion were simulatively formed, and convex portion test and concave portion test were performed on the single face. In the convex portion test, a copper jig so assembled as to give a compressibility of 30% to the thickness of a heat-conductive sheet was interposed, and this case was regarded as a convex portion of a heat-generating element. In the concave portion test, a heat-conductive sheet was gripped between a heat-generating element and a resin plate, then a copper jig so assembled as to give a compressibility of 5% to the thickness of a heat-dissipating spacer was interposed, and this case was regarded as a concave portion of a heat-generating element. In this manner, an electronic member for convex portion/concave portion test was prepared.

The prepared electronic member for convex portion/concave portion test was placed on a hot plate, and the hot plate was heated so that the copper jig had a temperature of 65°C.

<Heat generating temperature of convex portion/concave portion>

A 15-mmϕ (diameter) cylindrical copper jig protruding 30% as a convex portion and a 15-mmϕ (diameter) cylindrical copper jig protruding so as to give a compressibility of 5% as a concave portion were heated on a hot plate so that the copper face had a temperature of 65°C. A predetermined heat-conductive sheet was placed thereon. The heat-conductive sheet was attached to a PP resin plate having a thickness of 0.5 mm, and the temperature of the heat-dissipating spacer was measured through the plate with a thermoviewer. As the temperature of the heat-conductive sheet after heating for 5 minutes, the temperature around the center (diameter: 5 mmϕ) of the 15-mmϕ (diameter) cylinder was measured. The measurement was performed 5 minutes after the sheet was set to the jig.

The convex portion temperature difference 1 (°C) and the concave portion temperature difference 2 (°C) were calculated in accordance with set temperature - heat generating temperature. The temperature difference 3 (concave - convex) (°C) was calculated in accordance with concave portion temperature difference 2 - convex portion temperature difference 1.

<Heat resistances of convex portion and concave portion>

"Convex portion heat resistance (°C/W)" and "concave portion heat resistance (°C/W)" were numerical values by a provisional calculation of a temperature difference relative to the heater electric power (W) and were calculated in accordance with <Heat resistance> mentioned above.

<Contact area, ascertainment of air entrainment (noncontact portion)>

A 15-$mm^2$ transparent acrylic jig so protruding as to give a compressibility of 30% as a convex portion and a 15-$mm^2$ transparent acrylic jig so protruding as to give a compressibility of 5% as a concave portion were used, and a heat-conductive sheet was interposed so that the slit face was in contact with the acrylic resin. The heat-conductive sheet attached to a plate was used. Through the acrylic resin, the face in contact with the heat-conductive sheet was observed to ascertain air entrainment and noncontact portions.

Test Examples 38, 39, and 40 as comparative samples were heat-conductive sheets after a grooving process, and Test Examples 41 to 45 as samples were heat-conductive sheet after a slitting process. In Test Examples 38 to 40, the temperature difference, concave - convex, was 10°C or more even when the number of grooves was changed, and the heat conductivity deteriorated depending on compressibility. In Test Examples 41 to 45, the temperature difference,

concave - convex, was 5°C or less due to the slit shape effect, and excellent heat-conductive sheets were produced. In Test Examples 38 to 40, the concave portion giving a compressibility of 5% had a contact area of 120 $mm^2$ or less, and this indicates that the close contact area was small. It was also ascertained that air, which has a small heat conductivity, was present in the portions failing to be in close contact. In contrast, in Test Examples 41 to 45, the concave portion had a large contact area of 220 $mm^2$ or more, and this indicates that the close contact area was large. It was also ascertained that air intervention was not observed.

[Table 5]

| Test Example | 38 | 39 | 40 | 41 | 42 | 43 | 44 | 45 |
|---|---|---|---|---|---|---|---|---|
| | Comparative Example (groove) | Comparative Example (groove) | Comparative Example (groove) | Example (grid pattern) | Example (grid pattern) | Example (grid pattern) | Example (grid pattern) | Example (grid pattern) |
| Heat conductivity (W/mK) | 3 | 3 | 3 | 3 | 3 | 3 | 3 | 3 |
| Cut rate (%) | - | - | - | 50 | 50 | 50 | 50 | 50 |
| Cut depth (mm) | - | - | - | 0.25 | 0.5 | 1.5 | 2.5 | 5 |
| Uncut length (mm) | - | - | - | 0.25 | 0.5 | 1.5 | 2.5 | 5 |
| Thickness (mm) | 1 | 3 | 6 | 0.5 | 1 | 3 | 5 | 10 |
| Convex portion set temperature (°C) | 65 | 65 | 65 | 65 | 65 | 65 | 65 | 65 |
| Concave portion set temperature (°C) | 65 | 65 | 65 | 65 | 65 | 65 | 65 | 65 |
| Convex portion heat generating temperature (°C) | 60 | 59 | 59 | 64.9 | 64.7 | 64.5 | 64 | 63 |
| Concave portion heat generating temperature (°C) | 50 | 48 | 47 | 64.8 | 64.5 | 64 | 60 | 60 |
| Convex portion temperature difference 1 (°C) | 5 | 6 | 6 | 0.1 | 0.3 | 0.5 | 1 | 2 |
| Concave portion temperature difference 2 (°C) | 15 | 17 | 18 | 0.2 | 0.5 | 1 | 5 | 5 |
| Electric power (W) | 10 | 10 | 10 | 10 | 10 | 10 | 10 | 10 |
| Convex portion heat resistance (°C/W) | 0.50 | 0.60 | 0.60 | 0.01 | 0.03 | 0.05 | 0.10 | 0.20 |
| Concave portion heat resistance (°C/W) | 1.50 | 1.70 | 1.80 | 0.02 | 0.05 | 0.10 | 0.50 | 0.50 |

(continued)

| Test Example | 38 | 39 | 40 | 41 | 42 | 43 | 44 | 45 |
|---|---|---|---|---|---|---|---|---|
| | Comparative Example (groove) | Comparative Example (groove) | Comparative Example (groove) | Example (grid pattern) | Example (grid pattern) | Example (grid pattern) | Example (grid pattern) | Example (grid pattern) |
| Temperature difference 3 (concave - convex) | 10 | 11 | 12 | 0.1 | 0.2 | 0.5 | 4 | 3 |
| Contact area (mm2) (at a compressibility of 5%) | 115 | 60 | 60 | 235 | 235 | 235 | 235 | 235 |
| Air entrainment (noncontact portion) | × | × | × | ○ | ○ | ○ | ○ | ○ |

Test Example 38: a groove depth rate of 50%, a groove width of 1.5 mm, 5 grooves in the longitudinal direction

Test Examples 39 to 40: a groove depth rate of 50%, a groove width of 1.5 mm, 5 grooves in the longitudinal direction and 5 grooves in the transverse direction

Test Examples 41 to 45: a cut depth rate of 50%, a cut interval of 1.5 mm, grid pattern, 10 cuts/15 mm2 in each of the longitudinal direction and the transverse direction

Reference Signs List

| | |
|---|---|
| 1,1b | heat-conductive sheet |
| 2, 2b | cut |
| 3 | thickness |
| 4 | cut depth |
| 5 | cut interval |
| 10, 10b | electronic member |
| 11 | heat-generating member |
| 12 | cooling member |

## Claims

1. A heat-conductive sheet comprising a plurality of cuts on one or both faces of the sheet.

2. The heat-conductive sheet according to claim 1, wherein at least a part of a face formed by the cuts is in contact with at least a part of another face formed by the cuts.

3. The heat-conductive sheet according to claim 1 or 2, wherein the cuts do not penetrate the sheet.

4. The heat-conductive sheet according to any one of claims 1 to 3, wherein a depth ratio of the cuts is 2% to 90% of a thickness of the sheet.

5. The heat-conductive sheet according to any one of claims 1 to 4, comprising a plurality of sections formed by the cuts.

6. The heat-conductive sheet according to any one of claims 1 to 5, wherein the sheet has a compressive stress (at a compressibility of 20%) that is at least 5% smaller than a compressive stress before cutting.

7. The heat-conductive sheet according to any one of claims 1 to 6, wherein the sheet has an Asker C hardness of less than 40.

8. The heat-conductive sheet according to any one of claims 1 to 7, wherein the sheet comprises a silicone resin composition and an inorganic filler.

9. The heat-conductive sheet according to claim 8, wherein the inorganic filler is contained at 40 to 85% by volume.

10. The heat-conductive sheet according to claim 8 or 9, wherein the silicone resin composition is a two-component addition reaction type liquid silicone comprising an organopolysiloxane having a vinyl group at least at an end or on a side chain and an organopolysiloxane having two or more H-Si groups at least at an end or on a side chain.

11. A method for producing the heat-conductive sheet according to any one of claims 1 to 10.

[Fig. 1]

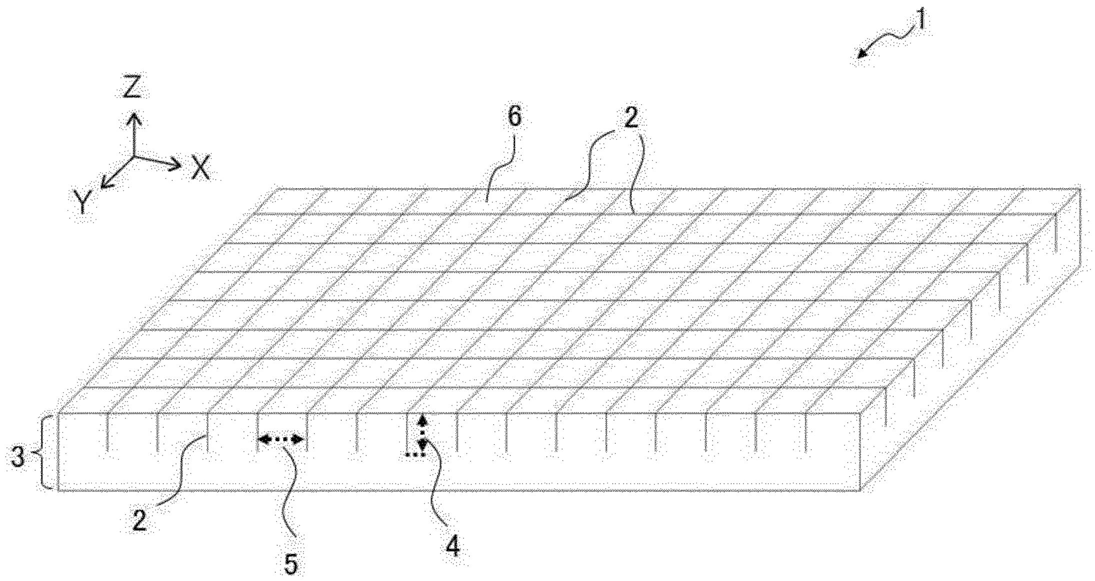

[Fig.2]

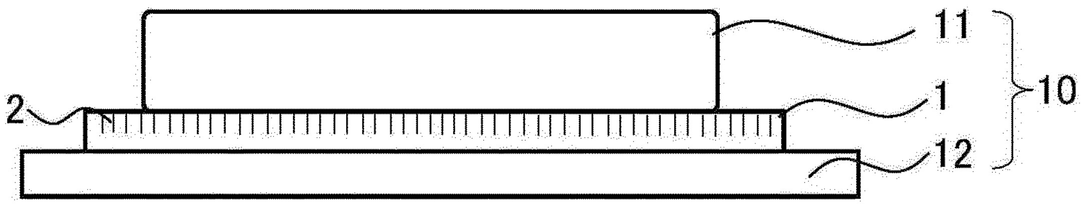


[Fig. 3]

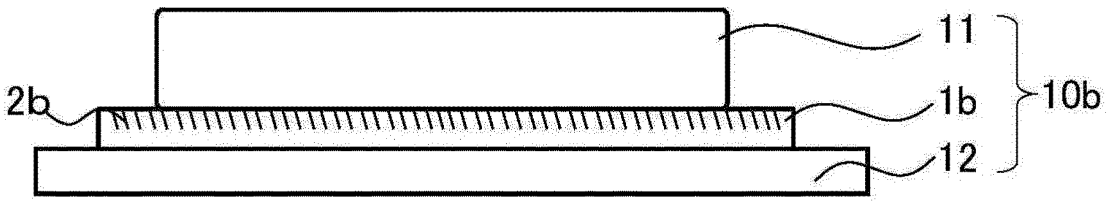

**INTERNATIONAL SEARCH REPORT**

International application No.
PCT/JP2018/014507

A. CLASSIFICATION OF SUBJECT MATTER
Int. Cl. H05K7/20(2006.01)i, C08K3/00(2018.01)i, C08L83/07(2006.01)i, C09K5/14(2006.01)i, H01L23/36(2006.01)i, H01L23/373(2006.01)i

According to International Patent Classification (IPC) or to both national classification and IPC

B. FIELDS SEARCHED

Minimum documentation searched (classification system followed by classification symbols)
Int. Cl. H05K7/20, C08K3/00, C08L83/07, C09K5/14, H01L23/36, H01L23/373

Documentation searched other than minimum documentation to the extent that such documents are included in the fields searched

| | |
|---|---|
| Published examined utility model applications of Japan | 1922-1996 |
| Published unexamined utility model applications of Japan | 1971-2018 |
| Registered utility model specifications of Japan | 1996-2018 |
| Published registered utility model applications of Japan | 1994-2018 |

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| X<br>Y | JP 2015-153743 A (HITACHI CONSTRUCTION MACHINERY CO., LTD.) 24 August 2015, paragraphs [0039]-[0049], fig. 10-13 (Family: none) | 1-6, 11<br>7-10 |
| X<br>Y | JP 2003-224386 A (TOYOTA MOTOR CORP.) 08 August 2003, paragraph [0030], fig. 3, 4 (Family: none) | 1-6, 11<br>7-10 |
| Y | JP 2015-071662 A (SHIN-ETSU CHEMICAL CO., LTD.) 16 April 2015, paragraphs [0001], [0006], [0007], [0058], [0059] (Family: none) | 7 |
| Y | JP 2000-108220 A (DENKI KAGAKU KOGYO KABUSHIKI KAISHA) 18 April 2000, paragraphs [0001], [0010]-[0013], [0017] (Family: none) | 8-10 |

☐ Further documents are listed in the continuation of Box C.  ☐ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| 13.06.2018 | 26.06.2018 |

| Name and mailing address of the ISA/ | Authorized officer |
|---|---|
| Japan Patent Office<br>3-4-3, Kasumigaseki, Chiyoda-ku,<br>Tokyo 100-8915, Japan | Telephone No. |

Form PCT/ISA/210 (second sheet) (January 2015)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- JP 2015092534 A